# EUROPEAN PATENT APPLICATION

(11) **EP 1 820 881 A2**
(43) Date of publication of application: **22.08.2007**
(21) Application number: 07101507.7
(22) Date of filing: 31.01.2007
(51) Int. Cl.: C23C 16/46, H01J 17/49

(54) **Low-K dielectric layers for large substrates**

(30) Priority: 10.02.2006 US 772593 P; 09.11.2006 US 558217
(71) Applicant: Applied Materials, Inc., Santa Clara, CA 95054 (US)
(72) Inventor: Stowell, Michael W., Loveland, 80538 (US); Dieguez-Campo, Jose M., 63457, Hanau (DE); Liehr, Michael, 36325, Feldatal (DE)
(74) Representative: Schickedanz, Willi

(57) **Abstract**

A system and method for producing a film is described. One embodiment of the process includes the following processes: providing a substrate comprising a glass plate, electrodes; and bus bars; heating the substrate to an approximate critical temperature; initiating the chemical vapor deposition process when the substrate is near the approximate critical temperature, thereby depositing a film on the substrate; maintaining the upper portion of the film at approximately the critical temperature while the chemical vapor deposition process is ongoing; terminating the chemical vapor deposition process once the film has reached a desired thickness; and cooling the substrate and the deposited film.

## Description

### PRIORITY

This application claims priority from commonly owned and assigned application no. 60/772,593, entitled "Low-K Dielectric Layer for Plasma Display Panels," and 11/558,217, entitled "Low-K Dielectric Layers for Large Substrates", which are incorporated herein by reference.

### FIELD OF THE INVENTION

Embodiments of the invention relate generally to plasma enhanced chemical vapor deposition techniques, and in particular, but not by way of limitation, to systems and methods for producing low-K dielectric layers for use in plasma display panels, solar panels, and other substrates. These low-K dielectric layers can enhanced device performance and result in electrical devices that consume significantly less power.

### BACKGROUND

Dielectric coatings with low dielectric constants (K) are currently manufactured in the semiconductor industry. For example, the semiconductor industry is currently depositing thin SiO₂ layers onto silicon wafers. These dielectric layers have dielectric constants in the 3-4 range. The semiconductor industry, however, has only been able to produce these dielectric layers on relatively small substrates - somewhere in the range of 1 to 12 inches currently. Moreover, the semiconductor industry only deposits thin dielectric layers - usually in the 5 to 25 nanometer range.

To build these thin, low-K dielectric layers, the semiconductor industry uses a process known as plasma enhanced chemical vapor deposition ("PECVD"). The general process of PECVD is well known and is used in many industries to deposit many types of thin films. But for the most part, PECVD has not been successful in producing thicker low-K dielectric layers on large scales. In particular, the PECVD process has been completely unsuccessful in depositing stable SiO₂ layers onto large substrates. The biggest failures of the industry to date include the inability to create dielectric layers in high-temperature processes and to create thick dielectric layers (e.g. thicker than 1 micron).

The failure of PECVD in producing dielectric layers on large substrates has been felt extensively by the plasma display panel ("PDP") industry. This industry is currently manufacturing plasma display panels over 102 inches in diagonal size. Dielectric layers are a necessary component of plasma display panels, but current PECVD processes have no way to deposit a stable low-K dielectric layer upon a substrate so large. As previously mentioned, the PECVD process is currently limited to depositing thin low-K dielectric layers on semiconductor wafers in the 12 inch range.

The primary reason that PECVD cannot be used to deposit low-K dielectric layers on large substrates is that the industry has not yet discovered how to manage thermal stresses and the resultant film cracking that results from coating large substrates, especially when thermally cycled. The plasma panel display industry would prefer to use PECVD to manufacture its dielectric layers, but simply cannot do so at this time.

With the failure of PECVD for depositing dielectric material, the plasma display panel industry is forced to rely on conventional technologies such as silkscreen printing and spin coating to place dielectric layers on large substrates. The silkscreen and spin coating processes are less desirable than the PECVD process.

Several problems exist with the conventional processes. First, these conventional processes result in a dielectric layer with an unusually high dielectric constant. Currently dielectric constants for dielectric layers applied through silkscreen or spin coating techniques run in the range of 15 instead of the desired 3-5 range. This high dielectric constant causes increased capacitance in the dielectric layer. And to accommodate this increased capacitance, plasma display panels must be operated at a higher voltage than they would if the dielectric constant of the dielectric layer was lower. The increase in operating voltage required by the high-K dielectric layers is significant. Currently, plasma display panels are operated at around 160-190 volts to overcome the extra capacitance and to supply the required light output level. Managing this high voltage, requires expensive semiconductor components, large power sources, and complicated heat dissipation hardware. Overall, the high-K dielectric layer currently used by plasma display panel manufacturers limits the size of plasma display panels and significantly increases the cost of those panels.

Another problem caused by the current material used for the dielectric layers in plasma display panels is the impurities in that material. These impurities are deliberately added to the dielectric material to lower its softening temperature so that it may properly adhere to the underlying substrate. The unfortunate side effect of these impurities is exhaust gasses that invade other materials in the plasma display panel during their deposition. These exhaust gasses significantly degrade other materials within the plasma display panel and cause even more voltage to be needed to operate the plasma display panel. The exhaust gasses and resulting higher voltages can also significantly shorten the life of a plasma display panel.

Assuming that the plasma display panel industry could replace the current high-K dielectric layers with low-K dielectric layers, it is anticipated that a 50% reduction in operating voltage could be achieved. It is also anticipated that the life span of a plasma display panel would be greatly extended. Taking these two factors into account, it is anticipated that the plasma display panel industry could reduce the manufacturing cost of a typical plasma display panel by 40 to 50%.

Unfortunately, with existing technology, there is no successful way to replace the conventionally applied silkscreened and spin coated high-K dielectric layer with a low-K dielectric layer. Thus, there is no way with existing technology to realize the above-mentioned power savings.

Accordingly, a new system, method and article manufacture are needed to address these and other problems known in the substrate coating industry. It should be noted that the problem is not limited to the plasma display panel industry and any solutions could be used not only for the plasma panel display industry but also for other industries, including the solar panel industry.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents and alternative constructions that fall within the spirit and scope of the invention as expressed in the claims.

A system and method for producing a film is described. One embodiment of the process includes the following processes: providing a substrate comprising a glass plate, electrodes; and bus bars; heating the substrate to an approximate critical temperature; initiating the chemical vapor deposition process when the substrate is near the approximate critical temperature, thereby depositing a film on the substrate; maintaining the upper portion of the film at approximately the critical temperature while the chemical vapor deposition process is ongoing; terminating the chemical vapor deposition process once the film has reached a desired thickness; and cooling the substrate and the deposited film.

Embodiments of the system described herein can result in significantly reduced manufacturing costs and significantly reduced power consumption. When the power consumption reduction is considered across the number of electrical appliances, e.g., plasma TVs, that could benefit because of the inventions described herein, significant power savings can be achieved.

As previously stated, the above-described embodiments and implementations are for illustration purposes only. Numerous other embodiments, implementations, and details of the invention are easily recognized by those of skill in the art from the following descriptions and claims.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawings wherein:
FIGURE 1 is a cross section of a typical plasma display panel constructed according to one embodiment of the present invention;
FIGURE 2 is a cross section diagram of a plasma display panel portion constructed according to one embodiment of the present invention;
FIGURE 3 is a chart of the surface temperature of the substrate and film surface when a dielectric layer is deposited according to the experimental, unsuccessful PECVD processes;
FIGURE 4 is a cross section of a plasma display panel portion manufactured according to the unsuccessful, experimental PECVD processes;
FIGURE 5 is a cross section of a dielectric layer applied according to conventional methods;
FIGURE 6 is a chart of the surface temperature of the substrate and film when a dielectric is deposited using a PECVD process in accordance with one embodiment of the present invention;
FIGURE 7A is a cross section of a plasma display panel portion constructed using the PECVD process according to one embodiment of the present invention;
FIGURE 7B is a flow chart showing one method of depositing a low-K dielectric film in accordance with one embodiment of the present invention;
FIGURE 8 is an enlargement of a portion of the plasma display panel illustrating pinch points caused by the PECVD process; and
FIGURE 9 is a cross section of a plasma display panel that includes a planarization layer.

### DETAILED DESCRIPTION OF THE INVENTION

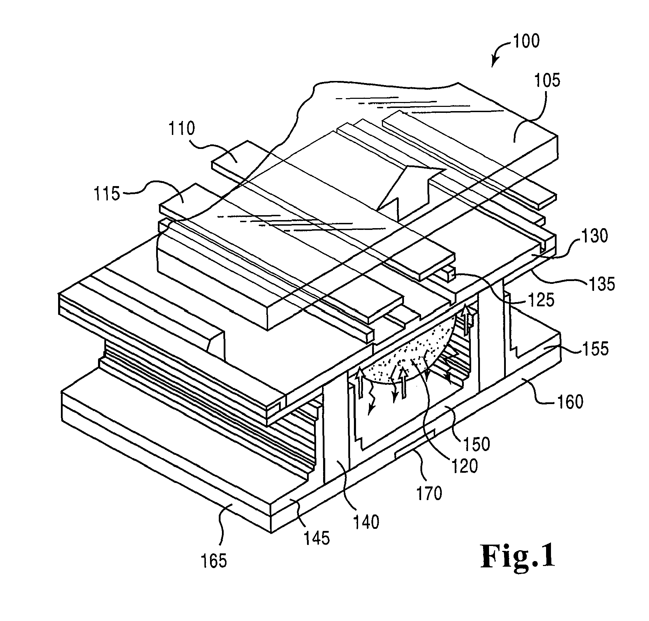

Referring now to Figure 1, it illustrates a cross section of one portion of a plasma display panel 100 constructed according to one embodiment of the present invention. For perspective, a viewer would view this plasma display panel through the top glass plate 105. For clarity, this plasma display panel 100 is described starting with the top glass plate 105 inward.

The top layer of this plasma display panel is the top glass plate 105. Secured to the inside of the glass plate are two electrodes known as the X and Y electrodes 110, 115. These electrodes carry the voltage necessary to drive the plasma display panel 100 and generate the necessary plasma 120. Typically these electrodes 110, 115 are formed of sputtered Indium Tin Oxide ("ITO"). ITO is a conductive, transparent material that does not interfere with light being emitted from the plasma display panel.

The X and Y electrodes 100, 115 are in contact with corresponding bus bars 125. These bus bars 125 are typically a silkscreened silver paste or a sputtered aluminum compound and are highly conductive.

Beneath the glass plate 105, electrodes 100, 115, and bus bars 125 is the upper dielectric layer 130. In conventional plasma display panels this upper dielectric layer is formed of a leaded glass material that is applied using silkscreen or spinning techniques. As previously mentioned, in conventional systems this upper dielectric layer generally has a high dielectric constant that is undesirable. In this embodiment of the present invention, however, the upper dielectric layer 130 is applied using a PECVD process controlled in a novel fashion to thereby produce a low-K dielectric layer.

Directly beneath this upper dielectric layer 130 is a protective layer 135. This protective layer is typically formed of magnesium oxide (MgO) and is deposited through electron beam processes. This protection layer 135 resists sputtering from the plasma, which is generally highly corrosive. Without this protective layer 135, the generated plasma would quickly destroy the dielectric layer 130, the bus bars 125, and the electrodes 100, 115.

This entire upper layer, consisting of the upper glass plate through the protection layer, is supported by a series of barrier ribs 140. These barrier ribs 140 provide a separation zone and also isolate particular color portions of the plasma display panel. As can be seen in FIGURE 1, the two barrier ribs 140 separate the red phosphor layer 145 from the blue phosphor layer 150 from the green phosphor layer 155. Thus, plasmas can be generated that produce light in a single color.

Underneath the various phosphor layers lies the lower dielectric layer 160. This lower dielectric layer 160 is typically applied to the lower glass plate using silkscreen or spinning techniques. The dielectric constant of this lower dielectric layer 160 is not as critical as the dielectric constant of the upper dielectric layer 130. Accordingly, silkscreen and spinning techniques are generally acceptable to apply the lower dielectric layer 160. In some embodiments, a PECVD process can be used.

Sandwiched between the lower dielectric layer 160 and the lower glass plate 165 is the addressing electrode 170. This electrode 170 is typically a silkscreened silver paste or a sputtered aluminum compound. The addressing electrode 170 is used to select particular pixels within a plasma display panel for activation.

The plasma display panel in Figure 1 is shown admitting blue light in the shown region. Initially the region for illumination is selected by applying a voltage to the addressing electrode 170. The voltage differential on the X and Y electrodes 100, 115 causes a voltage differential on the inside of the protection layer 135. This voltage differential is typically referred to as the "wall voltage." Assuming that the wall voltage is high enough, the gas between the two barrier ribs to becomes excited 120. Typically, this gas is either neon or xenon. The excited gas, or plasma, bombards the blue phosphor layer 150 with ultra violet radiation, thereby causing the blue phosphor layer 150 to emit a visible blue light.

In current plasma display panels, the voltage applied at the X and Y electrodes is approximately 160-190 volts. Due to the capacitance caused by conventional upper dielectric layers, the voltage drop between the electrodes and the wall voltage is significant. Stated differently, because of the high dielectric constant of conventional dielectric layers, a significantly higher voltage must be applied at the X and Y electrodes to achieve a sufficient wall voltage to create the necessary plasma.

Using one embodiment of the present invention with the novel upper dielectric layer, however, the wall voltage and electrode voltage are closer together. In one set of experiments, the voltage applied to the electrodes needed to sustain the plasma was approximately 90 volts rather than 190 volts with the conventional dielectric layer.

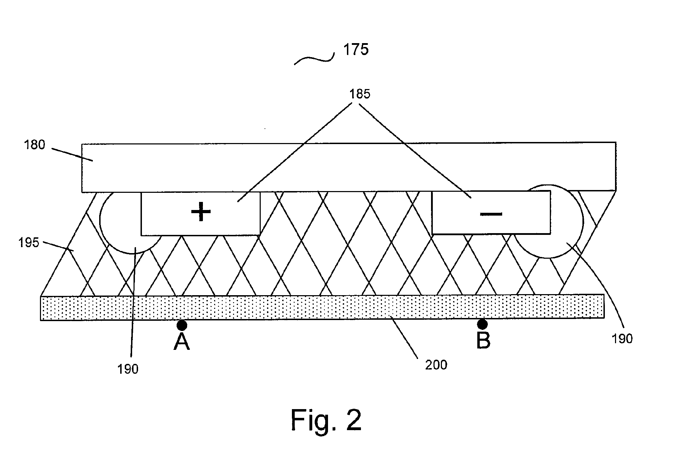

Referring now to FIGURE 2, it illustrates a cross section diagram of a plasma display panel 175 constructed in accordance with one embodiment of the present invention. This embodiment illustrates the top glass plate 180, the electrodes 185, the bus bars 190, the dielectric layer 195 constructed in accordance with one embodiment of the present invention, and the protective layer 200. Points A and B are marked to indicate where a wall voltage might be measured. It should be noted, however, that points A and B are imaginary points and are identified for discussion purposes only.

Because of the lower-K dielectric constant of the dielectric layer 195 of the present invention, the voltage applied at the electrodes is better transferred to the wall voltage points A and B than it would be using the prior art high-K dielectric layers - meaning that the panel can be operated at lower voltage.

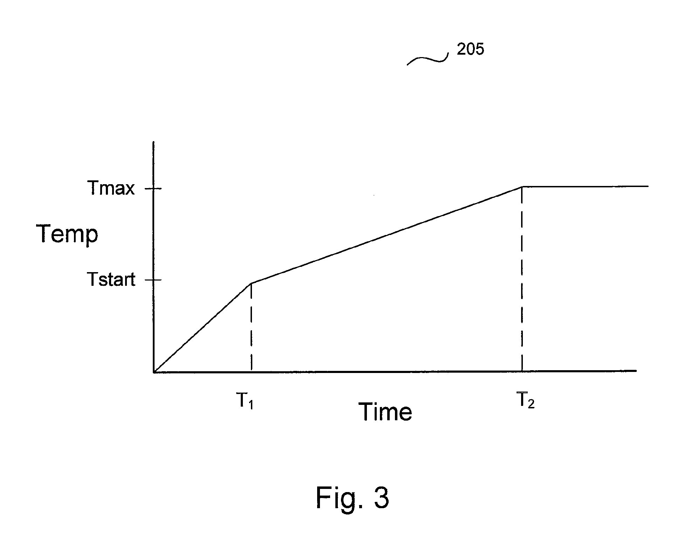

Referring now to FIGURE 3, it is a chart 205 of the surface temperature of the substrate and dielectric when attempts are made to deposit a low-K dielectric material using a PECVD process in accordance with unsuccessful, experimental methods. This chart indicates the surface temperature of the front glass plate and the upper most layer of the upper dielectric layer as the dielectric layer is being deposited through previous, unsuccessful PECVD processes. As previously described, dielectric layers applied according to this typical PECVD process are wholly unacceptable because they cracked and are unusable. The plasma display panel industry has tried to limit this cracking but has been unsuccessful prior to the improvements described herein.

The unsuccessful PECVD methods for depositing a dielectric layer on a large substrate involved external heaters heating a substrate to a starting temperature - shown as Tstart. When the substrate temperature reached that starting temperature, at time T1, then the PECVD process was initiated. At this point the external heaters were either turned off or turned down. (The PECVD process and methods of controlling the PECVD process are well known and not described further.) But as is shown in FIGURE 3, even when the external heaters are turned off at T1, the temperature of the surface of the substrate and dielectric layer continues to climb. This increase in surface temperature, even without the presence of an external heat source, is caused by exothermic reactions on the surface of the growing film.

For example, the typical PECVD process for depositing a dielectric layer, such as SiO₂, uses a precursor gas known as HMDSO. When disassociated during the PECVD process, HMDSO forms SiOx and hopefully SiO₂. (This process of disassociating HMDSO is known to those of skill in the art and not described in detail herein.) The SiOx radicals and other radicals deposit on the surface of the substrate and existing film. The heat of that film surface causes further breakdown and chemical reaction of the deposited material. This further breakdown results in additional exothermic reactions, thereby generating additional heat, which causes further chemical breakdown, which generates even more heat. This cycle continues until the film layer reaches a critical temperature or maximum temperature. In FIGURE 3, this maximum temperature is reached at time T2 and is indicated by Tmax. The critical temperature represents the approximate maximum temperature that the growing film will reach due to an exothermic reaction. Alternatively, the critical temperature is generally the temperature at which the exothermic reaction no longer adds heat to the surface of the film or if it does add heat, the heat no longer impacts film growth.

It has been discovered that these exothermic reactions and the corresponding increase in surface temperature from times T1 to T2 are responsible for the cracking that the plasma display panel industry has been experiencing in its PECVD-applied dielectric layers. It is believed that these exothermic reactions, by adding heat to the PECVD process, are changing the density of the dielectric layer as it grows.

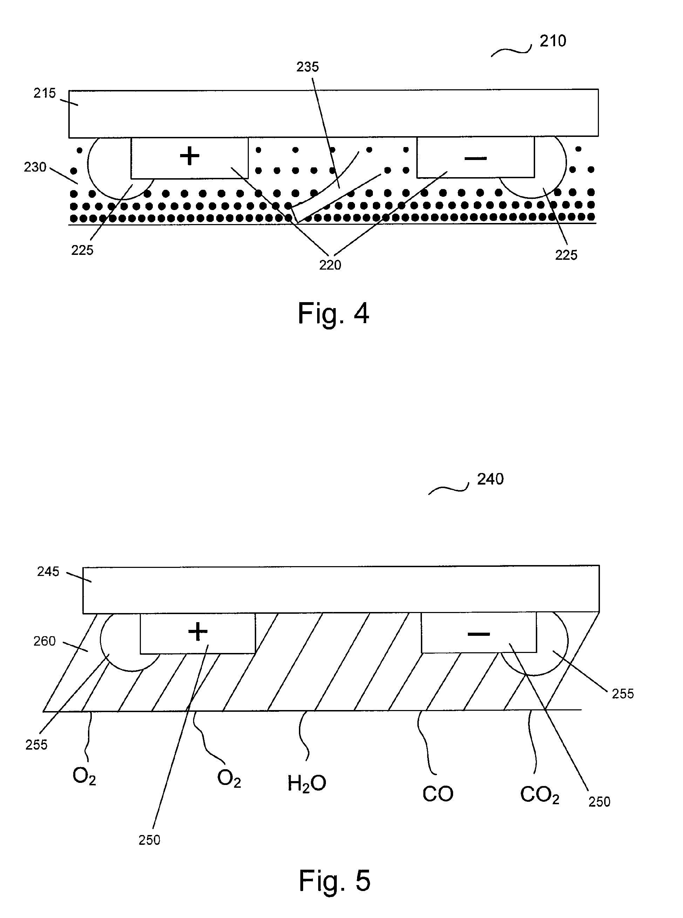

Referring now to FIGURE 4, it illustrates a diagram of a dielectric layer 210 deposited through unsuccessful, experimental PECVD techniques. This plasma display panel illustrates the top glass panel 215, the electrodes 220, the bus bars 225, and a PECVD-deposited dielectric layer 230. The dots in the dielectric layer represent the density of SiOx within the dielectric layer. As can be seen, the density increases from the outer portion of the dielectric layer to the inner portion of the dielectric layer. This increase in density corresponds to the increase in heat added to the PECVD process by the exothermic reactions. For instance, the less-dense portion of the dielectric layer nearest the glass panel would be deposited at approximately time T1 and the more-dense portion of the dielectric layer would be deposited at approximately time T2.

The problem with the dielectric layer shown in FIGURE 4 is that it will crack 235 as it cools. The varying densities of SiOx within the dielectric layer 230 cause the dielectric layer 230 to have a varying thermal expansion coefficient - meaning that as the dielectric layer cools from its initial deposition, different portions of the film contract at different rates, thereby causing the dielectric layer 230 to crack 235. This cracking can be so violent that it causes the dielectric layer 230 to completely detach from the underlying substrate. Further, this cracking problem is so pronounced that the plasma display panel industry has been unable to successfully deposit dielectric layers on large substrates using PECVD. And as previously discussed, the industry has been forced to rely upon the much less desirable techniques of silkscreen application and spin coating application.

Referring now to FIGURE 5, it illustrates a dielectric layer 240 placed by the traditional techniques of silkscreening and spin coating. Again, these are the techniques currently used by the plasma display panel industry. This diagram illustrates the glass plate 245, the electrodes 250, the bus bars 255 and the dielectric layer 260.

Ideally, this dielectric layer 260 would be pure SiO₂. Unfortunately, the softening temperature of pure SiO₂ is too high for the plasma display panel manufacturing process. At the temperatures required to soften a pure SiO₂ dielectric layer, the glass plate would be damaged. To overcome the high softening temperature of SiO₂ dielectric layers, the industry has adopted a practice of adding impurities to the dielectric material. Typically the dielectric material that is applied by silkscreen or spin coating techniques is a combination of SiO₂ and PbO, ZnO or BaO. Collectively these glasses are often referred to as "lead" glass.

Although these impurities lower the softening temperature of the dielectric material to an acceptable point so that they can be applied by traditional techniques, the impurities do result in significant negative side effects. One of those side effects is that the impurities increase the dielectric constant of the dielectric material. Typically the lead glass used in current plasma display panel manufacturing has a dielectric constant in the 10 to 16 K range. As is known to those of skill in the art, increasing the dielectric constant causes an increase in capacitance. Thus, the lead glass, with its high dielectric constant, acts as a relatively large capacitor. This increased capacitance causes additional voltage to be needed to drive the plasma display panel. In fact, this increased capacitance results in significant extra costs in manufacturing a plasma display panel.

Another negative side effect of the impurities is that the lead glass must be unusually thick to provide the proper breakdown voltages. Typically lead glass used in the current plasma display panel industry is between 25 and 30 micrometers thick.

And yet another drawback of using lead glass is that lead glass, when heated, exhausts impurities such as O₂, H₂O, CO and CO₂. These impurities are released, for example, during the deposition of the protective layer and disrupt the formation of that layer. Typically these exhausted waste gases decrease the density of the protective layer, change the actual physical structure of the protective layer, and leave impurities directly in the protective layer.

Recall that the protective layer is designed to resist the plasma that forms inside the plasma display panel. Plasma is extremely corrosive and without the protective layer, the plasma would destroy the upper dielectric layer, the electrodes, the bus bars and eventually the upper glass plate. Protective layers, such as magnesium oxide MgO, resist the corrosive effects of plasma. But impurities introduced into the protective layer significantly reduce the protective layer's ability to resist the plasma. Accordingly, these waste gases exhausted by lead glass dielectric layers reduce the effectiveness of the protective layer.

It has also been discovered that these impurities negatively effect the electrical properties of the protective layer.

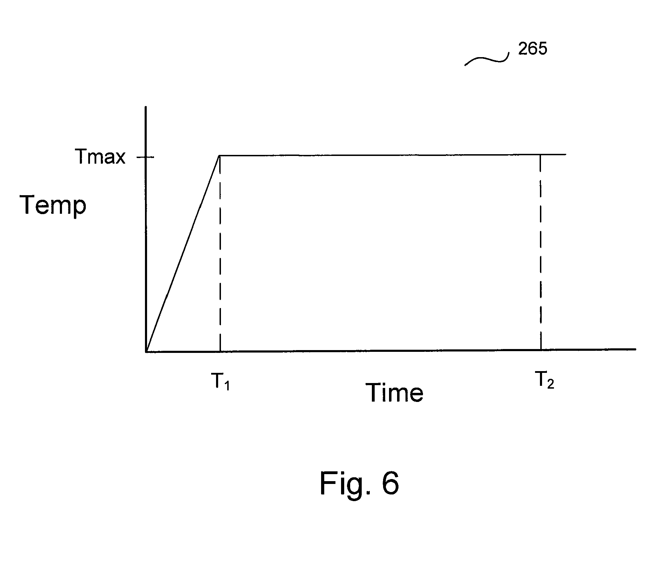

Referring now to FIGURE 6, it is a chart 265 that illustrates the surface temperature of a substrate in a dielectric film deposited using a PECVD process operated in accordance with one embodiment of the present invention. As this chart shows, a substrate is heated to the critical temperature, shown as Tmax, using an external heater. Recall that this critical temperature is approximately the temperature at which the exothermic reactions no longer impact the density of a deposited dielectric layer. In one embodiment, the critical temperature was around 240°C for a SiO₂ film. Once the substrate is heated to this critical temperature, the external heater can be turned off or reduced - leaving the exothermic reaction to maintain a constant or near constant temperature on the growing film's surface. This process helps create a uniform density within the dielectric layer. The exothermic reaction and the resulting heat can be changed by changing the deposition rate. For example, the power applied to the antenna during the deposition process can be reduced. This reduction will cause a drop in the deposition rate. Alternatively, the power signal - including frequency, duty cycle, pulse shape - applied during the deposition process can be varied.

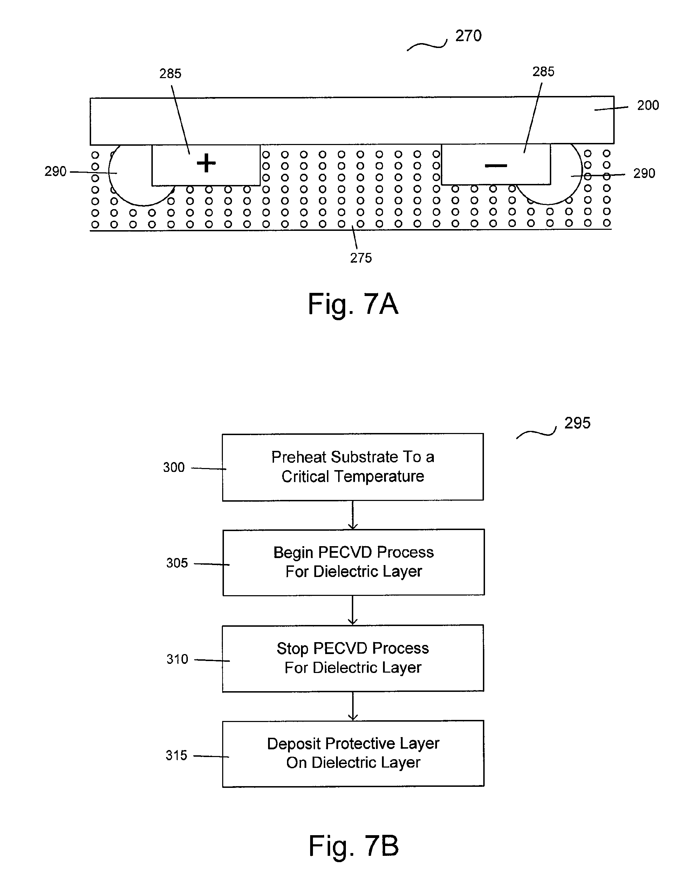

Referring now to FIGURE 7A, it illustrates a plasma display panel 270 with a dielectric layer 275 deposited according to the teachings of one embodiment of the present invention. As with the previous plasma display panels, this panel includes the top glass plate 280, the electrodes 285, and the bus bars 290. This plasma display panel portion also includes a low-K dielectric layer 275 that has a uniform density or near uniform density throughout. This uniform density results from controlling the exothermic reactions and controlling the film surface temperature during the PECVD process. This type of uniform density provides a near uniform thermal expansion coefficient throughout the entire dielectric layer. Accordingly, as the dielectric layer cools it does not crack or only cracks an insignificant amount. This type of dielectric layer 275 provides a low dielectric constant, presents low capacitance, and provides a good surface for depositing the protective layer.

FIGURE 7B illustrates one series of steps 295 to create the dielectric layer of FIGURE 7A - although these steps are not limited to plasma display panels and are not limited to creating dielectric layers. Because the basic PECVD process is well known in the prior art, the basic details of PECVD are not included in this flow chart. Instead this flow chart focuses on recent advances that make it possible to create low-K dielectric layers on large substrates.

In this process the substrate such as the glass panel is initially heated to a critical temperature. [Block 300] This critical temperature will vary according to substrate type, precursor gas process variations, desired dielectric layer thickness, and desired dielectric constant values. Those of skill in the art will understand how to calculate critical temperatures for the particular process parameters and outcomes desired for their particular implementation. Additionally, critical temperatures can be determined easily for particular process parameters and desired outcome through readily available experimental techniques.

After the substrate is preheated to the critical temperature, the PECVD process can begin and the dielectric layer can be deposited on the substrate. [Block 305] Alternatively a different type of layer could be deposited. At this point the external heat can either be turned off or reduced, thereby allowing the exothermic reactions on the film surface to generate the necessary heat to maintain the film surface at or near the critical temperature. Once the dielectric layer has reached the desired thickness, the PECVD process for depositing the dielectric layer can be terminated. [Block 310] At that point the next layer, the protective layer, can be deposited upon the dielectric layer using known PECVD or other techniques. [Block 315]

This process can be used dynamically as well as statically to produce plasma display panels. In existing systems, the process was limited to static application. But with the PECVD deposition process of this embodiment of the present invention, the dielectric layer and protective layer can be applied in a dynamic fashion, thereby reducing manufacturing cost and manufacturing time.

This process has successfully grown dielectric layers up to 65 micrometers thick that have not cracked during cooling. The ideal thickness for dielectric layers in plasma display panels is between 5 and 25 micrometers, and layers 1 micrometer and greater are contemplated. The PECVD process described herein has also successfully produced dielectric layers in this thickness range. Such dielectric layers have shown a heat resistance up to 560°C, a 98% transmission factor, and a dielectric constant in the 4-5 range - less than the 10 currently requested by the industry. One series of tests shows that 50 volts less are required for firing the panel, and 35 volts less are required for sustaining the plasma within the plasma display panel than with conventional dielectric materials. Better results have been achieved in other tests.

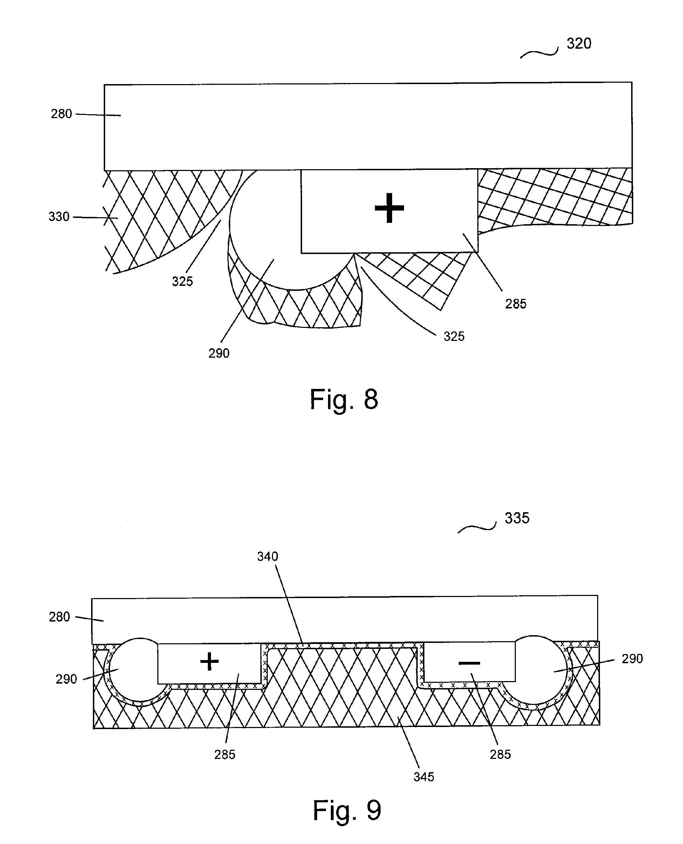

Referring now to FIGURE 8, one problem can arise when using PECVD to deposit low-K dielectric layers on large substrates. This problem is pinch point formation. PECVD generally results in a uniform distribution of deposited material. However, in plasma display panel deposition, the electrodes and bus bars can create a shadowing effect that disrupts even deposition of dielectric material.

FIGURE 8 illustrates an exaggerated view of the pinch points 325 created by the shadowing effect. These pinch points 325 affect the breakdown voltage of the dielectric layer 330 and provide a weakness by which plasma can attack the electrodes 285 and bus bars 290.

FIGURE 9 illustrates a plasma display panel portion 335 with a planarization layer 340 and a dielectric layer 345 deposited by PECVD in accordance with embodiments of the present invention. This planarization layer 340 reduces the impact of pinch points, and can be deposited by a variety of methods, including silk screening, spin coating, plasma processes, and chemical vapor deposition processes.

This embodiment illustrates the glass layer 280, the electrodes 285, the bus bars 290, and the dielectric layer 345. This embodiment also includes a planarization layer 340 between the dielectric layer and the other components. The planarization layer 340 can be a thin lead glass material generally in the range of 20 nanometers to 2000 nanometers thick. This lead glass layer can be applied by traditional silkscreening and spin coating techniques. It has been discovered that these thin planarization layers reduce the effects of shadowing.

Moreover, it has been discovered that the addition of a planarization layer further reduces the overall capacitance between the electrodes and the protective layer. Recall that capacitance is a major problem because it requires extra voltage to be applied at the electrodes to drive the plasma display panel. But by placing the planarization layer and the dielectric layer of the present invention in series, the overall capacitance is significantly reduced. Effectively, these two separate layers act as series capacitors.

In another embodiment, two planarization layers are used. The first planarization layer is adjacent to the glass layer 280 and the electrodes 285. This layer is similar to planarization layer 340. The second planarization layer is placed on top of the dielectric layer 345. These two layers effectively sandwich the dielectric layer 345. And in another embodiment, the only planarization layer used is the second planarization layer. These planarization layers can be extremely thin. For example, they can be less than 500 nanometers thick. Generally, the planarization layers are between 250 nanometers and 500 nanometers thick.
In conclusion, the present invention provides, among other things, a system and method for producing thin films, such as dielectric layers, for use in several industries. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

**1.** A method for depositing a dielectric layer using PECVD, the method comprising:
heating a substrate approximately to a critical temperature, wherein the critical temperature corresponds to a precursor gas;
introducing the precursor gas into a process chamber at approximately the time that the substrate is near the critical temperature;
disassociating the precursor gas, thereby forming deposition material; and
depositing the deposition material to thereby form a film.

**2.** The method of claim 1, wherein the deposition material forms a top film layer of the dielectric layer, the method further comprising:
maintaining the top film layer at approximately a constant temperature.

**3.** The method of claim 1, wherein the deposition material forms a top film layer of the dielectric layer, the method further comprising:
maintaining the top film layer at approximately the critical temperature.

**4.** The method of claim 1, wherein the precursor gas comprises HMDSO.

**5.** The method of claim 1, wherein depositing the deposition material comprises:
forming a film with a near uniform density throughout the film.

**6.** The method of claim 1, wherein depositing the deposition material comprises:
forming a film with a dielectric constant near or below 5.

**7.** The method of claim 1, wherein preheating the substrate to near the critical temperature, comprises:
preheating a portion of a plasma display panel.

**8.** The method of claim 1, further comprising:
depositing a protective layer on the film, the protective layer providing a resistance to plasma.

**9.** The method of claim 8, wherein depositing the protective layer on the film comprises:
using plasma enhanced chemical vapor deposition to deposit the protective layer.

**10.** The method of claim 1, wherein depositing the deposition material comprises:
depositing the deposition material to thereby form a film approximately between 5 and 25 micrometers thick.

**11.** The method of claim 1, wherein depositing the deposition material comprises:
depositing the deposition material to thereby form a film greater than 1 micrometer thick.

**12.** The method of claim 1, wherein depositing the deposition material comprises:
depositing the deposition material to thereby form a film greater than 25 micrometers thick.

**13.** The method of claim 1, further comprising:
depositing a planarization layer on the substrate;
wherein depositing the deposition material comprises depositing the deposition material on the planarization layer.

**14.** The method of claim 1, further comprising:
depositing a planarization layer on the film.

**15.** The method of claim 14, further comprising:
depositing a protective layer on the planarization layer.

**16.** The method of claim 14, wherein depositing the planarization layer comprises:
depositing a planarization layer less than 500 nanometers thick.

**17.** The method of claim 14, wherein depositing the planarization layer comprises:
depositing through a silk screen, spin coating, or plasma process.

**18.** A method for creating a plasma display panel, the method comprising:
providing a substrate comprising a glass plate, electrodes; and bus bars;
heating the substrate to an approximate critical temperature;
initiating the deposition process when the substrate is near the approximate critical temperature, thereby depositing a film;
maintaining an upper portion of the film at approximately the critical temperature while the deposition process is ongoing;
terminating the deposition process once the film has reached a desired thickness; and
cooling the substrate and the deposited film.

**19.** The method of claim 18, wherein terminating comprises:
terminating the deposition process when the film is greater than 5 micrometers thick.

**20.** The method of claim 18, wherein the deposited film has a dielectric constant less than 10.

**21.** The method of claim 18, further comprising:
depositing a protective layer on the deposited film.

**22.** The method of claim 21, further comprising:
dynamically depositing the protective layer on the deposited film.

**23.** The method of claim 18, further comprising:
depositing a planarization layer on the substrate, wherein the film is deposited on the planarization layer.

**24.** The method of claim 18, further comprising:
depositing a planarization layer on the film.

**25.** A plasma display panel portion comprising:
a glass layer;
a plurality of electrodes;
a plurality of bus bars;
a dielectric layer deposited using a plasma enhanced chemical vapor deposition process; and
a protective layer.

**26.** The plasma display panel portion of claim 25, wherein the dielectric layer is greater than 5 micrometers thick.

**27.** The plasma display panel portion of claim 25, wherein the dielectric layer has a dielectric constant below approximately 5.

**28.** The plasma display panel portion of claim 25, wherein the dielectric layer has a dielectric constant below approximately 10.

**29.** The plasma display panel portion of claim 25, further comprising: a planarization layer between the glass layer and the dielectric layer.

**30.** The plasma display panel portion of claim 25, further comprising: a planarization layer between the dielectric layer and the protective layer.
